# EUROPEAN PATENT APPLICATION

(11) **EP 4 575 601 A1**
(43) Date of publication of application: **25.06.2025**
(21) Application number: 24219212.8
(22) Date of filing: 11.12.2024
(51) Int. Cl.: G02B 6/43, H03K 19/17728, G02B 6/12, H10D 62/80

(54) **A DEVICE, COMPUTER PROGRAM AND METHOD**

(30) Priority: 22.12.2023 GB 202319997
(71) Applicant: Sony Semiconductor Solutions Corporation, Atsugi-shi, Kanagawa 243-0014 (JP)
(72) Inventor: AVITABILE, Antonio, Basingstoke, RG22 4SB (GB); LAVIZZARI, Simone, Basingstoke, RG22 4SB (GB)
(74) Representative: D Young & Co LLP

(57) **Abstract**

A method of selecting an optical path through a photonic circuit between an input port and an output port, wherein there are a plurality of different optical pathways connecting the input port and the output port and each optical pathway is configured to contain a plurality of constituent elements, the method comprising: establishing at least one property of each of the constituent elements; and selecting the optical pathway based upon the established at least one property

## Description

### BACKGROUND

### Field of the Disclosure

The present technique relates to a device, computer program and method.

### Description of the Related Art

The "background" description provided herein is for the purpose of generally presenting the context of the disclosure. Work of the presently named inventors, to the extent it is described in the background section, as well as aspects of the description which may not otherwise qualify as prior art at the time of filing, are neither expressly or impliedly admitted as prior art against the present technique.

Over recent years, Programmable Photonic Circuits have been developed. These consist of a large number of waveguide meshes of tunable couplers that connect multiple optical inputs with multiple optical outputs. This allows for optical connections to be made without the need to convert the optical light into an electrical signal for routing and then converting the electrical signal back into an optical signal for sending over a fibre connection. This allows very high bandwidth, low latency communication over wireless telecommunication infrastructure, for example.

However, the waveguides have optical losses. In other words, as the light passes through the waveguide, some light leaks from the waveguide. This is undesirable as the signal to noise ratio reduces as light is lost. Also, leakage from one waveguide may result in cross-talk with another waveguide.

It is an aim of the disclosure to address at least one of these issues.

### SUMMARY

According to embodiments of the disclosure, there is provided a method of selecting an optical path through a photonic circuit between an input port and an output port, wherein there are a plurality of different optical pathways connecting the input port and the output port and each optical pathway is configured to contain a plurality of constituent elements, the method comprising: establishing at least one property of each of the constituent elements; and selecting the optical pathway based upon the established at least one property.

The foregoing paragraphs have been provided by way of general introduction, and are not intended to limit the scope of the following claims. The described embodiments, together with further advantages, will be best understood by reference to the following detailed description taken in conjunction with the accompanying drawings.

### BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:
Figure 1 shows a photonic circuit;
Figure 2 shows a configurable photonic circuit 100 according to embodiments of the disclosure;
Figure 3 shows a detector 105 according to embodiments;
Figure 4 show a controller according to embodiments;
Figure 5 shows the data associated with each section;
Figures 6A and 6B show a User Interface according to embodiments; and
Figure 7 shows a process according to embodiments which is performed by the controller.

### DESCRIPTION OF THE EMBODIMENTS

Referring now to the drawings, wherein like reference numerals designate identical or corresponding parts throughout the several views.

Numerous modifications and variations of the present disclosure are possible in light of the above teachings. It is therefore to be understood that within the scope of the appended claims, the disclosure may be practiced otherwise than as specifically described herein.

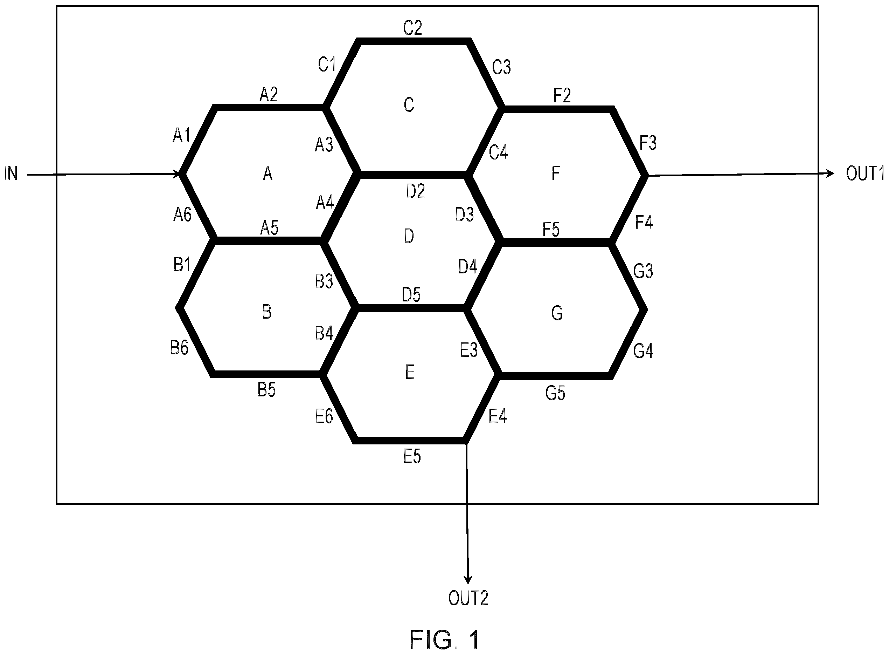

Figure 1 shows a photonic circuit in general. A photonic circuit has a mesh of optical pathways formed of sections. These sections are formed by waveguides on a semiconductor substrate. For example, the waveguides are formed on a silicon substrate. In particular, where the semiconductor substrate is silicon, a layer of SiO₂ is deposited on the Silicon and the sections of the optical pathway formed of Silicon or Silicon Nitrate (SiN) is formed within the SiO₂ to act as the section of the optical pathway. Of course the disclosure is not so limited and may include Barium titanate (BTO) or Lithium niobate (LiNbOs) or the like. It is now possible to form configurable photonic chips such as those developed at the Politecnico di Milano in its collaboration with Scuola Superiore Sant'Anna in Pisa, the University of Glasgow and Stanford University as part of the European Horizon 2020 Superpixels project.

Returning to Figure 1, the photonic circuit has, in this case, one input (IN) and two outputs (OUT1 and OUT2). With a configurable photonic chip, it is possible to route the optical pathway between the input IN and one or both of the outputs OUT1, OUT2. For example, in the situation where the optical pathway between IN and OUT1 is required, the constituent sections A6, B1, B6, B5, B4, D5, D4, F5 and F4 may be used. Alternatively, the optical pathway may be formed from constituent sections A 1, A2, A3, D2, D3, F5, F4. In fact, there are many possible alternative constituent sections which may form a between the input IN and output OUT1.

A similar situation arises where an optical pathway between the input IN and output OUT2 is required. Specifically, the optical light may follow a path along constituent sections A6, A5, B3, B4, EG, E5 or sections A1, A2, A3, A4, B3, B4, E6, E5. Again, there are many sections that may make up the optical pathway between the input and output OUT2.

As will be appreciated, it is possible to select the appropriate constituent sections to form the optical pathway by providing phase shifters and a tunable coupler which can be configured between a bar and cross-state in the constituent sections. These arrangements are known and were demonstrated by the Polytechnical University of Valencia where a programmable 7 hexagonal cell circuit.

In instances, the selection of the constituent sections used is arbitrary and simply the selection of an optical pathway is sufficient. This is particularly the case where the system is instructed to switch optical pathways between outputs (i.e. from OUT1 to OUT2 for example). In other words, it is the selection of any constituent sections that form the optical pathway between the input and output that is important rather than the specific constituent sections forming that pathway.

The inventors have realised that with a configurable photonic circuit, it is desirable to select the most appropriate route between the input and either or both outputs. In other words, careful selection of the constituent sections forming the optical pathway can improve the performance of the configurable photonic circuit. In embodiments, the most appropriate route is selected based upon at least one property of the constituent sections making up the optical pathway. In embodiments, this at least one property is the optical loss along the respective constituent sections. However, it should be appreciated that the disclosure is not so limited and other criteria may be used when determining the most appropriate route. For example, the length of the constituent sections may be used as this would impact not only optical loss but also latency within the configurable photonic circuit as the further the light needs to travel, the higher the latency.

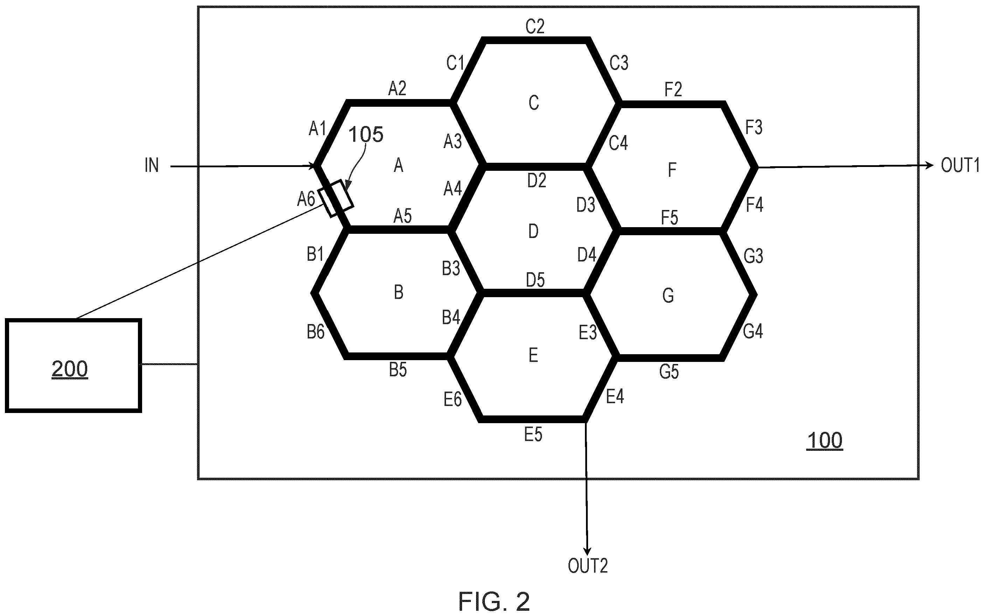

Figure 2 shows a configurable photonic circuit 100 according to embodiments of the disclosure.

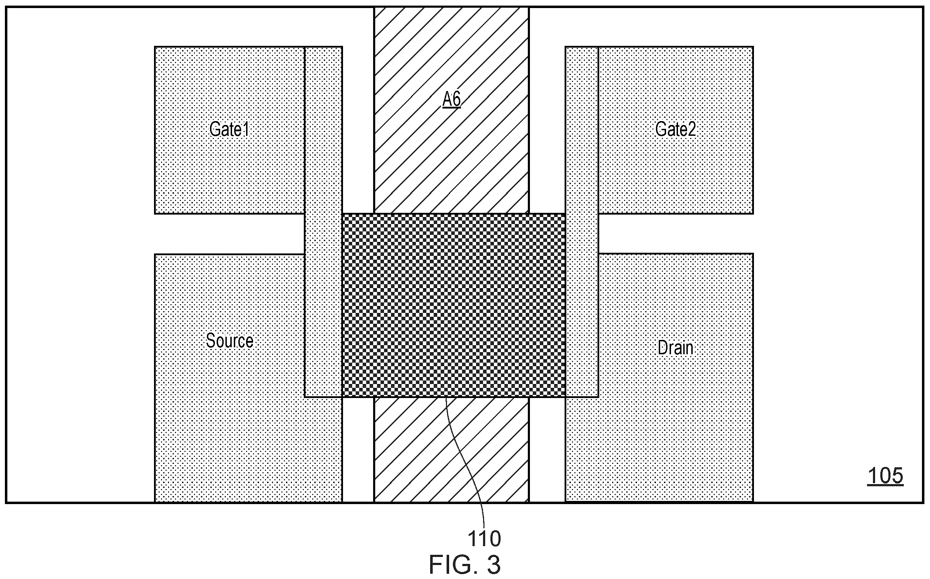

In the configurable photonic circuit 100 according to embodiments, a detector 105 is located on constituent section A6. The structure of the detector 105 according to embodiments will be described with reference to Figure 3. However, the purpose of the detector 105 is to detect optical light emanating from the constituent section A6. This emanating optical light will form optical losses from the constituent section A6 which reduces the signal to noise ratio and increases cross-talk between the constituent sections. The detector 105 is therefore located along at least part of the constituent section A6 to measure the optical losses.

In embodiments, the detector 105 may be located anywhere along the constituent section. However, in embodiments, the detector 105 may be located near junctions between different constituent sections. This is because the optical losses tend to be worse near to junctions and so placing detectors 105 so that the optical losses are measured at the junctions improves the determined optical pathway.

It should be noted that whilst Figure 2 shows a single detector 105, it is envisaged that, in embodiments, there will be multiple detectors 105 and, in instances, one or more detectors 105 along each constituent section.

Figure 3 shows a detector 105 according to embodiments. Although it is envisaged that any detector 105 that is capable of detecting and measuring the optical light emanating from the constituent section A6, the inventors have identified one particular type of detector 105 that is particularly useful.

In particular, it is envisaged that the detector 105, in embodiments will be formed of one or more graphene patch. A detector 105 formed of one or more graphene patch is particularly advantageous for a number of reasons. Firstly, graphene easily absorbs light in the range of 1µm-3 µm. This wavelength of light is typically used in photonic circuits formed on a Silicon substrate. Further, graphene detectors are unbiased meaning that there is zero power consumption in the idle state. Furthermore, graphene detects high data rate signals due to its high electron mobility.

Referring to Figure 3, a detector 105 is shown. The detector 105 sits above a waveguide shown which forms part of the constituent section A6. The detector 105 and has a source, drain and two gates (gate 1 and gate 2). A graphene patch 110 is positioned between the two gates and over the waveguide. The graphene patch 110 may be directly deposited on the SiOz layer or may be encapsulated to avoid contamination. In embodiments, the graphene patch may be encapsulated with Al₂O₃ to preserve the layer of graphene and avoid contamination. Although a single patch of graphene is shown, the disclosure is not so limited and a multi-patch structure is envisaged which may be used to cover a more complex circuit.

An example of the detector 105 is described in [1], the contents of which is hereby incorporated by reference. In particular, and not limiting, the content of [1] which describes the manufacture and operation of the graphene detector is incorporated by reference.

Referring back to Figure 2, the output from the detector 105 is fed to a controller 200. In addition, controller 200 is connected to the configurable photonic circuit 100. The controller 200 is configured to control the operation of the configurable photonic circuit 100 by selecting the optical pathway and the constituent sections which form the optical pathway based upon, at least, the output of the or each detector 105. In other words, the controller 200 controls the tunable couplers and the phase shifters within the constituent sections of the optical pathway in the configurable photonic circuit 100 to control the flow of light through the constituent sections.

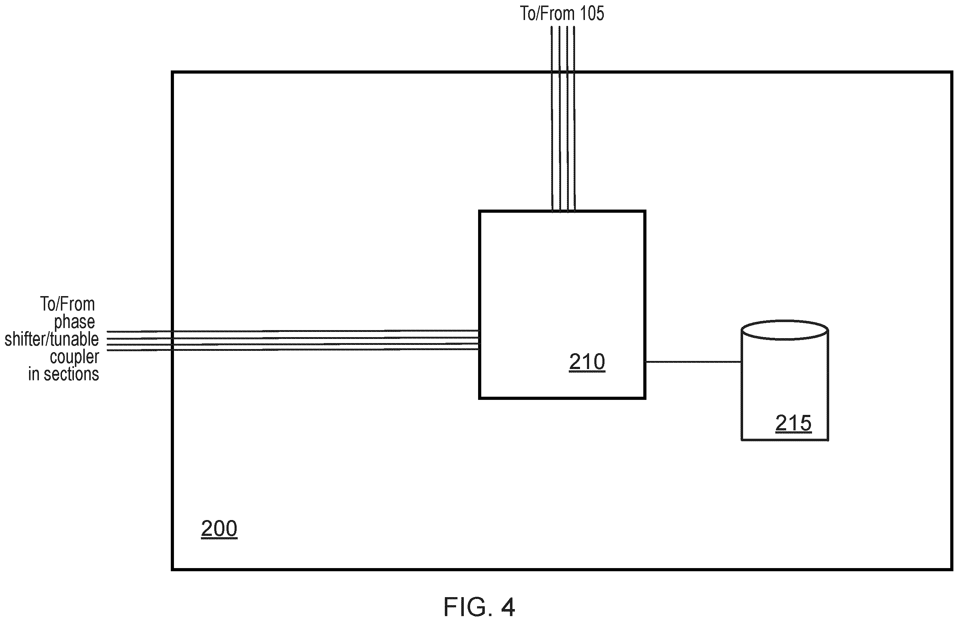

Referring to Figure 4, the controller 200 according to embodiments is shown. The controller 200 includes connections to each of the detectors 105 within the configurable photonic circuit 100. This allows the output from each detector 105 to be provided to the controller 200 as will be explained later. Furthermore, the controller 200 includes connections to each of the constituent sections to control the phase shifters and/or tunable couplers within the constituent sections. It will be appreciated, that although Figure 4 shows a direct connection between the controller 200 and each detector 105 and the tunable couplers and phase shifters, the disclosure is not so limited and the controller 200 may be connected via any kind of arrangement and a direct connection is not required.

In embodiments, a control section 210 is provided in the controller 200. In embodiments, the control section 210 is solid-state circuitry such as an Application Specific Integrated Circuit or, in embodiments, is circuitry whose operation is controlled using computer software. In addition, storage 215 is provided. In embodiments, the storage 215 is solid state circuitry configured to store data associated with each constituent section and computer readable code which, when loaded onto the control section 210 configures the control section 210 to perform steps according to embodiments of the disclosure.

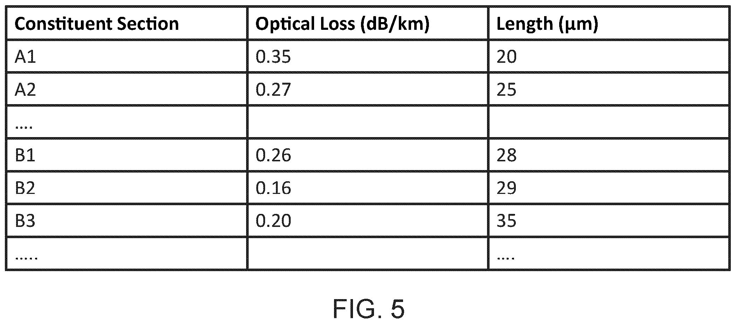

The data associated with each section stored within storage 215 is shown in Figure 5. Specifically, Figure 5 shows a table that associates at least one property of the constituent section with the constituent section. In embodiments, the at least one property includes the optical loss along the constituent section and/or the length of the constituent section. It shall be noted that the disclosure is not limited to any one property of the constituent section and any one or more property may be chosen as will be appreciated Moreover, the one or more property of one or more constituent sections may be used to determine the optical pathway. For example, the optical loss across many constituent sections may be used to determine the optical pathway.

It will be understood that the property of the constituent section is updated periodically. In embodiments, this update will occur regularly (maybe twice every second) or may occur when the difference between the stored value and the current value is above a threshold. For example, if the optical loss along a constituent section changes by greater than a threshold amount such as 0.05 dB/km is the property updated. The optical loss value will be provided by the detector 105 which is connected to the controller 200 and the controller 200 will update the stored optical loss value. In embodiments, the output from the detector 105 may be amplified before being provided to the controller 200.

It will also be understood that the length of the constituent section is unlikely to change as it is defined by the length of the waveguide.

Moreover, although the constituent section has been described as being part of a waveguide, the disclosure is not so limited. In fact, a constituent section may include any part of an optical pathway such as an optical switch or coupler or the like. In other words, the terms 'constituent section' may include any element that forms part of an optical pathway such as a waveguide (or part thereof), coupler, optical switch or the like. In embodiments, the graphene detector is used to measure the optical loss at the element. However, the disclosure is not so limited and the optical loss (or other property) may be determined at the constituent element using any appropriate mechanism.

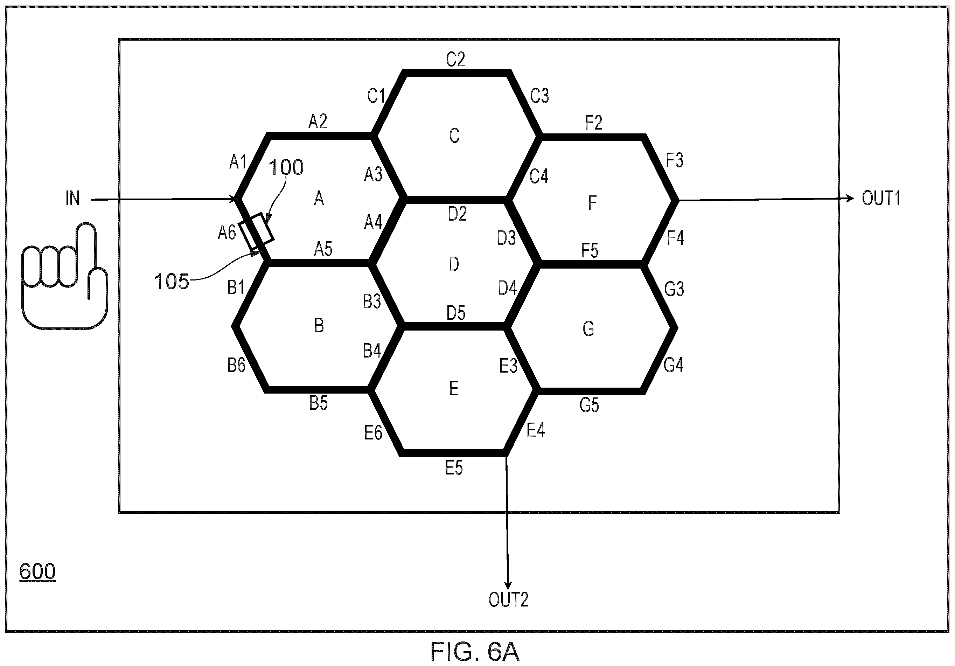

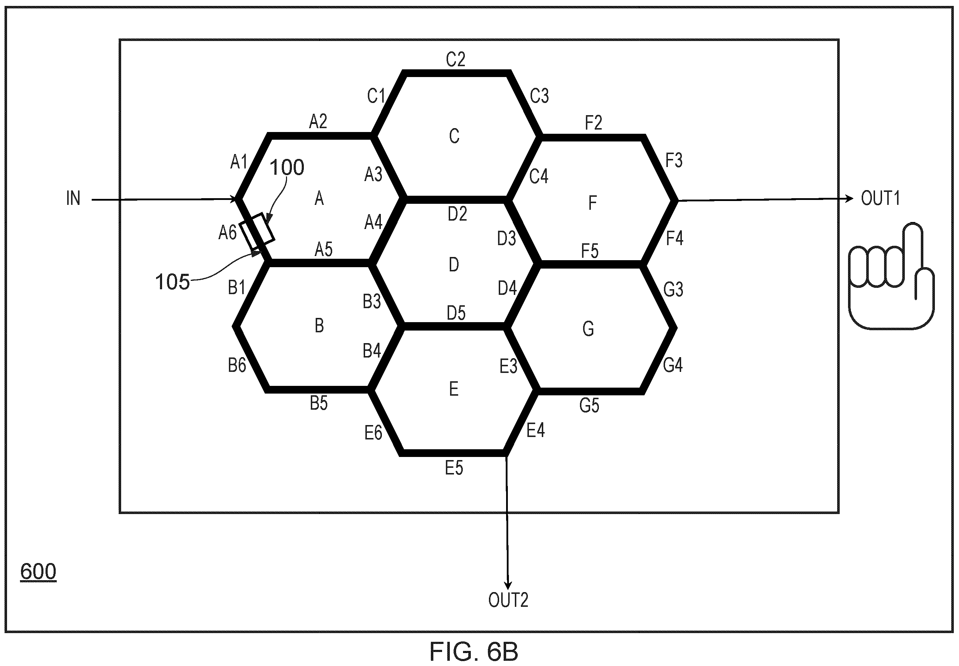

Figures 6A and 6B show a User Interface according to embodiments. In embodiments, the User Interface shows a schematic diagram of the photonic circuit with the input (IN) and outputs (OUT1 and OUT2). Of course, the disclosure is not so limited and the User Interface may be in any configuration that allows the user to control the controller 200. In embodiments, the User Interface is displayed on a display 600 that has a touch screen allowing the user to control the operation of the controller 200 using a touch screen. Of course, the disclosure is not so limited and any type of display and user control element (such as a mouse or the like) is envisaged.

Anyway, in embodiments, the user touches the input (in Figure 6A) and then touches one of the outputs. In this case, the user touches OUT1. This user control instructs the controller 200 to create an optical pathway between IN and OUT1. Of course, any equivalent control is envisaged and any number of input(s) and/or output(s) is envisaged.

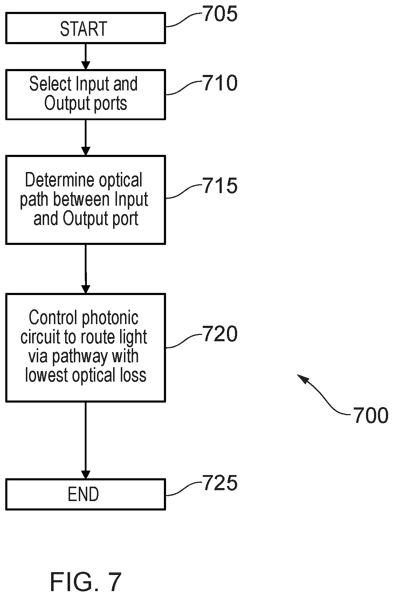

The controller 200 then selects the optical path based upon one or more of the properties of the constituent section stored in the table shown in Figure 5. This selection process will be described with reference to Figure 7.

Figure 7 shows a process 700 according to embodiments which is performed by the controller 200. The process starts at step 705. The process then moves to step 710 where the input and output port is selected. In embodiments, this is performed by the user, but in embodiments, this is performed by an external controller which selects the input and output ports based on one or more other criteria such as routing an input optical fibre port to a different optical fibre output port.

The process then moves to step 715 where the various paths between the selected input port and output port are processed so that one optical pathway is determined. This may be performed, in embodiments, using Dijkstra's algorithm whereby the property or properties of interest are used as the cost of a vector. In other words, in embodiments, using Dijkstra's algorithm, the optical loss property will provide a cost of each vector and in embodiments, the length of each constituent section will also provide a cost of each vector. Of course, the disclosure is not so limited and any property or properties may provide a cost of each vector. Moreover, the disclosure is not limited to using Dijkstra's algorithm and any suitable routing algorithm is envisaged.

After the optical pathway between the input port and the output port is determined, the process moves to step 720 where the controller 200 controls the photonic circuit to route the light via a pathway having the lowest cost. In other words, in embodiments, the controller will control the photonic circuit to route the light according to the property which is used in the Dijkstra algorithm. As will be appreciated, this control will be performed by controlling the phase shifters and/or tunable couplers (not shown) which are provided within a photonic circuit. This control of the phase shifters and tunable couplers is using known techniques.

The process then moves to step 725 where the process 700 ends.

In addition to establishing the optical pathway between an input and an output (or between a plurality of inputs and outputs), in embodiments, the controller 200 also controls the output power of the input emitter. This control may be via direct control of the input emitter or by issuing commands to the input emitter. In embodiments, the term 'input emitter' means the provider of the optical light at the input port, which, in embodiments, is a laser.

Specifically, for any given required optical power at the output port, as the controller 200 has determined the optical loss along the optical pathway, the controller 200 informs the input emitter of the optical power required at the input port to achieve a given output optical power. This allows the input emitter to dynamically change the input optical power to achieve a certain output laser power. This improves energy efficiency of the system whilst ensuring there is sufficient optical power for an output port. Of course, although the foregoing describes the use of optical loss as the property, the disclosure is not so limited and any property is envisaged.

### Other Embodiments

The above describes a dynamic routing technique that determines the optical pathway between an input and an output port based on at least one property of the photonic circuit. However, in other embodiments, the manufacture associated with production of the photonic circuit is evaluated using similar principles.

Specifically, for a given photonic circuit, the detectors 105 are located on each of the constituent sections. The optical loss is measured for each constituent section and stored in storage 215. However, rather than using this to determine the optical pathway between the input and the output as described above, instead, in embodiments this optical loss information for each constituent section is used to evaluate the manufacture of the photonic circuit.

In embodiments, the optical loss for each constituent section is stored and compared with the previous iteration of the manufacturing process. For example, in the previous iteration of the manufactured photonic circuit, the level of SiN doping used in the constituent sections of the optical pathways may be different to the level of SiN doping in the current iteration. Accordingly, it is possible to evaluate whether, for example, the previous level or the current level of doping is better.

This allows the manufacturer to determine the most appropriate manufacturing techniques and processes to reduce optical loss. In other words, for each new iteration of a photonic circuit under development, the graphene detectors 105 are used to establish the optical loss along at least one of or Dijskeach constituent section and the manufacturer can iterate their manufacturing technique to reduce the optical loss in one or more constituent sections to a particular level.

In so far as embodiments of the disclosure have been described as being implemented, at least in part, by software-controlled data processing apparatus, it will be appreciated that a non-transitory machine-readable medium carrying such software, such as an optical disk, a magnetic disk, semiconductor memory or the like, is also considered to represent an embodiment of the present disclosure.

It will be appreciated that the above description for clarity has described embodiments with reference to different functional units, circuitry and/or processors. However, it will be apparent that any suitable distribution of functionality between different functional units, circuitry and/or processors may be used without detracting from the embodiments.

Described embodiments may be implemented in any suitable form including hardware, software, firmware or any combination of these. Described embodiments may optionally be implemented at least partly as computer software running on one or more data processors and/or digital signal processors. The elements and components of any embodiment may be physically, functionally and logically implemented in any suitable way. Indeed the functionality may be implemented in a single unit, in a plurality of units or as part of other functional units. As such, the disclosed embodiments may be implemented in a single unit or may be physically and functionally distributed between different units, circuitry and/or processors.

Although the present disclosure has been described in connection with some embodiments, it is not intended to be limited to the specific form set forth herein. Additionally, although a feature may appear to be described in connection with particular embodiments, one skilled in the art would recognize that various features of the described embodiments may be combined in any manner suitable to implement the technique.

### References

[1] Photo thermal effect graphene detector featuring 105 Gbit s⁻¹ NRZ and 120 Gbit s⁻¹ PAM 4 direct detection - S. Marconi, A. Giambra *et al.* Nature Communications https://doi.org/10.1038/s41467-021-21137-z

Embodiments of the present technique can generally described by the following numbered clauses:
1. A method of selecting an optical path through a photonic circuit between an input port and an output port, wherein there are a plurality of different optical pathways connecting the input port and the output port and each optical pathway is configured to contain a plurality of constituent elements, the method comprising:
   establishing at least one property of each of the constituent elements; and
   selecting the optical pathway based upon the established at least one property.
2. A method according to clause 1, wherein the at least one property is optical loss along the constituent element and the method further comprises: establishing the optical losses using a graphene photodetector.
3. A method according to clause 1 or 2, wherein the at least one property is the length of each constituent element.
4. A method according to any preceding clause further comprising:
   controlling the output power of an emitter of light received at the input port based upon the at least one property.
5. A method according to any preceding clause, wherein the optical pathway is selected using Dijkstra's algorithm
6. A method of evaluating the manufacture of a photonic circuit having a plurality of different optical pathways each containing a plurality of constituent elements, the method comprising:
   establishing the optical loss along at least one of the plurality of constituent elements using a detector made of graphene placed on the at least one constituent elements; and
   evaluating the photonic circuit based on the established optical loss.
7. A device for selecting an optical path through a photonic circuit between an input port and an output port, wherein there are a plurality of different optical pathways connecting the input port and the output port and each optical pathway is configured to contain a plurality of constituent elements, the device comprising circuitry configured to:
   establish at least one property of each of the constituent elements; and
   select the optical pathway based upon the established at least one property.
8. A device according to clause 7, wherein the at least one property is optical loss along the constituent element and the circuitry is configured to: establish the optical losses using a graphene photodetector.
9. A device according to clause 7 or 8, wherein the at least one property is the length of each constituent element.
10. A device according to any one of clauses 7 to 9, wherein the circuitry is further configured to:
   control the output power of an emitter of light received at the input port based upon the at least one property.
11. A device according to any one of clauses 7 to 10, wherein the optical pathway is selected using Dijkstra's algorithm
12. A device for evaluating the manufacture of a photonic circuit having a plurality of different optical pathways each containing a plurality of constituent elements, the device comprising circuitry configured to:
   establish the optical loss along at least one of the plurality of constituent elements using a detector made of graphene placed on the at least one constituent elements; and
   evaluate the photonic circuit based on the established optical loss.
13. A computer program comprising computer readable code which, when loaded onto a computer, configures the computer to perform the method according to any one of clauses 1 to 6.
14. A computer program product comprising the computer program of clause 13 stored therein or thereon

## Claims

1. A method of selecting an optical path through a photonic circuit between an input port and an output port, wherein there are a plurality of different optical pathways connecting the input port and the output port and each optical pathway is configured to contain a plurality of constituent elements, the method comprising:
establishing at least one property of each of the constituent elements; and
selecting the optical pathway based upon the established at least one property.

2. A method according to claim 1, wherein the at least one property is optical loss along the constituent element and the method further comprises: establishing the optical losses using a graphene photodetector.

3. A method according to claim 1, wherein the at least one property is the length of each constituent element.

4. A method according to claim 1 further comprising:
controlling the output power of an emitter of light received at the input port based upon the at least one property.

5. A method according to claim 1, wherein the optical pathway is selected using Dijkstra's algorithm

6. A method of evaluating the manufacture of a photonic circuit having a plurality of different optical pathways each containing a plurality of constituent elements, the method comprising:
establishing the optical loss along at least one of the plurality of constituent elements using a detector made of graphene placed on the at least one constituent elements; and
evaluating the photonic circuit based on the established optical loss.

7. A device for selecting an optical path through a photonic circuit between an input port and an output port, wherein there are a plurality of different optical pathways connecting the input port and the output port and each optical pathway is configured to contain a plurality of constituent elements, the device comprising circuitry configured to:
establish at least one property of each of the constituent elements; and
select the optical pathway based upon the established at least one property.

8. A device according to claim 7, wherein the at least one property is optical loss along the constituent element and the circuitry is configured to: establish the optical losses using a graphene photodetector.

9. A device according to claim 7, wherein the at least one property is the length of each constituent element.

10. A device according to claim 7, wherein the circuitry is further configured to:
control the output power of an emitter of light received at the input port based upon the at least one property.

11. A device according to claim 7, wherein the optical pathway is selected using Dijkstra's algorithm

12. A device for evaluating the manufacture of a photonic circuit having a plurality of different optical pathways each containing a plurality of constituent elements, the device comprising circuitry configured to:
establish the optical loss along at least one of the plurality of constituent elements using a detector made of graphene placed on the at least one constituent elements; and
evaluate the photonic circuit based on the established optical loss.

13. A computer program comprising computer readable code which, when loaded onto a computer, configures the computer to perform the method according to claim 1.

14. A computer program product comprising the computer program of claim 13 stored therein or thereon.
